(19)

Europäisches Patentamt

European Patent Office

Office européen des brevets

(11) **EP 4 391 732 A1**

(12) **EUROPEAN PATENT APPLICATION**
published in accordance with Art. 153(4) EPC

(43) Date of publication:
**26.06.2024 Bulletin 2024/26**

(21) Application number: **22866781.2**

(22) Date of filing: **09.09.2022**

(51) International Patent Classification (IPC):
**H05K 1/02** (2006.01)

(52) Cooperative Patent Classification (CPC):
**H05K 1/02**

(86) International application number:
**PCT/CN2022/118256**

(87) International publication number:
**WO 2023/036320 (16.03.2023 Gazette 2023/11)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **13.09.2021 CN 202111068756**

(71) Applicant: **Huawei Technologies Co., Ltd.
Shenzhen, Guangdong 518129 (CN)**

(72) Inventors:
• **CHENG, Dingning
Shenzhen, Guangdong 518129 (CN)**
• **LIU, Chenjun
Shenzhen, Guangdong 518129 (CN)**
• **DING, Xueying
Shenzhen, Guangdong 518129 (CN)**
• **ZHAO, Caijun
Shenzhen, Guangdong 518129 (CN)**
• **CHENG, Weichang
Shenzhen, Guangdong 518129 (CN)**
• **ZHAO, Zhenyuan
Shenzhen, Guangdong 518129 (CN)**

(74) Representative: **Gill Jennings & Every LLP
The Broadgate Tower
20 Primrose Street
London EC2A 2ES (GB)**

(54) **MULTI-LAYER CIRCUIT BOARD, CIRCUIT BOARD ASSEMBLY, AND ELECTRONIC DEVICE**

(57) This application provides a multilayer circuit board, a circuit board assembly, and an electronic device. The multilayer circuit board includes a differential signal line, a reference ground layer, and a stub structure. The differential signal line and the reference ground layer are located at different layers of the multilayer circuit board. The stub structure includes a main stub and an auxiliary stub, where one end of the main stub is connected to the reference ground layer, and the auxiliary stub is connected to the main stub. The stub structure of the multilayer circuit board and a nearby conductive structure form a capacitor-inductor equivalent structure, which is equivalent to disposing a capacitor-inductor resonant circuit. In the stub structure, only the one end of the main stub is connected to the reference ground layer, and none of remaining parts is connected to the reference ground layer. Filtering effect of the stub structure is good, and a common-mode interference signal with a higher frequency can be suppressed. The stub structure is a simple structure and occupies less space. This is beneficial to meeting high-frequency and high-density wiring requirements of the multilayer circuit board. In addition, a toler-ance capability of the multilayer circuit board in a preparation process is strong.

FIG. 5

# Description

## CROSS-REFERENCE TO RELATED APPLICATIONS

This application claims priority to Chinese Patent Application No. 202111068756.6, filed with the China National Intellectual Property Administration on September 13, 2021 and entitled "MULTILAYER CIRCUIT BOARD, CIRCUIT BOARD ASSEMBLY, AND ELECTRONIC DEVICE", which is incorporated herein by reference in its entirety.

## TECHNICAL FIELD

This application relates to the field of electronic technologies, and specifically, to a multilayer circuit board, a circuit board assembly, and an electronic device.

## BACKGROUND

Because electronic devices generate electromagnetic noise during operation, and the electromagnetic noise interferes with other surrounding electronic devices, only products that have passed a related test like electromagnetic compatibility (Electro Magnetic Compatibility, EMC) certification can be launched to the market.

With continuous development of communication technologies, an operating rate of a chip of an electronic product continuously increases. As a result, an electromagnetic radiation test frequency band for product EMC certification increases from 30 MHz to 1 GHz to 30 MHz to 6 GHz. The FCC standard of the United States requires a maximum electromagnetic radiation test frequency band of 40 GHz. Generally, common-mode noise generated by high-speed chips is main noise in high-frequency electromagnetic radiation signals. The common-mode noise excites a high-speed differential signal line of a circuit board for propagation, and then propagates to various types of high-speed connectors. The foregoing connectors are generally antennas with a strong radiation capability, and may radiate the common-mode noise, causing electromagnetic interference.

An existing implementation for suppressing electromagnetic interference is to suppress common-mode noise at board level. From the perspective of technologies such as a defected ground structure (Defected Ground Structure, DGS) filter, a wiring filter, and a balanced broadband tunable common-mode filter disclosed in the industry, structure sizes of these filters are too large to meet high-frequency and high-density layout and wiring requirements of current products. Especially, some products have many high-speed differential signal line channels, and a spacing between differential signal line pairs is less than 1 mm.

# SUMMARY

This application provides a multilayer circuit board, a circuit board assembly, and an electronic device, so as to improve a frequency of common-mode noise suppressed by the multilayer circuit board, reduce an area occupied by a common-mode noise suppression structure, improve a high-density layout of the multilayer circuit board, and improve a tolerance capability of the multilayer circuit board in a preparation process.

According to a first aspect, this application provides a multilayer circuit board, where the multilayer circuit board includes a differential signal line, a reference ground layer, and a stub structure. A layer of the differential signal line on the multilayer circuit board is different from a layer of the reference ground layer on the multilayer circuit board. In other words, the differential signal line and the reference ground layer are located at different layers of the multilayer circuit board. The differential signal line is configured to transmit a differential signal, and the reference ground layer is configured to form a reference signal, to improve accuracy of a signal transmitted by the multilayer circuit board. The stub structure includes a main stub and an auxiliary stub, and the auxiliary stub is connected to the main stub as an integrated structure. In the stub structure, only one end of the main stub is connected to the reference ground layer, the other end of the main stub is not connected to the reference ground layer, and the auxiliary stub is not connected to the reference ground layer either. In the technical solutions of this application, the stub structure of the multilayer circuit board and a nearby conductive structure form a capacitor-inductor equivalent structure, which is equivalent to disposing a capacitor-inductor resonant circuit on the multilayer circuit board. An electric field and a magnetic field generated by a common-mode interference signal are closely coupled with the capacitor-inductor resonant circuit formed by the stub structure, to suppress common-mode noise. Only the one end of the main stub is connected to the reference ground layer, and none of remaining parts is connected to the reference ground layer. In this solution, an end that is of the main stub and that is not connected to the reference ground layer may also form an equivalent capacitor. Therefore, compared with an equivalent capacitor formed by a stub structure that is of a same size and shape and that has the main stub whose two ends are connected to the reference ground layer, the equivalent capacitor formed in the technical solution of this application is large, and a resonance frequency of the common-mode noise that can be suppressed is higher. In other words, based on a same resonance frequency requirement for suppressing the common-mode noise, a stub in the technical solution of this application may be small and occupy a small board area. In addition, the stub structure is a simple structure, includes only the main stub and the auxiliary stub, and occupies less space. Therefore, the solution is beneficial to meeting high-frequency and high-density wiring requirements of the multilayer circuit board. The stub structure has a simple structure and a small size, the stub structure may be prepared at a long distance from adjacent wiring, and even if there is an offset in each part of the structure during preparation of the multilayer circuit board, a problem like a short circuit is not likely to occur. Therefore, a tolerance capability of the multilayer circuit board in the preparation process is strong.

When the stub structure is specifically prepared, a length (a first length) that is of the stub structure and that is parallel to an extension direction of the differential signal line may be less than or equal to 2 mm. The size of the stub structure in the technical solutions of this application is small, which helps reduce the board area occupied by the stub structure.

A length (a second length) that is of the stub structure and that is perpendicular to the extension direction of the differential signal line is less than or equal to 1 mm. Similarly, the size of the stub structure in the technical solutions of this application is small, which helps reduce the board area occupied by the stub structure (where the board area is equal to the first length * the second length). For example, the board area occupied by the stub structure may be less than or equal to 2 mm$^2$.

The frequency of the common-mode noise that can be suppressed by the stub structure in this technical solution is greater than or equal to 10 GHz, to increase the frequency of the common-mode noise that can be suppressed.

In addition, the auxiliary stub is symmetrically disposed on two sides of the main stub. Specifically, a length direction of the main stub is parallel to a symmetry axis of the auxiliary stub. It may be considered that a symmetry axis of the main stub extending in the length direction overlaps with the symmetry axis of the auxiliary stub. In this solution, the entire stub structure can be a symmetric structure. This is beneficial to forming a symmetric magnetic field and a symmetric electric field, so that symmetry of the differential signal line is not easy to be damaged.

The specific shape of the stub structure is not limited. For example, the stub structure is in a cross shape, a T shape, an E shape, or a Ψ shape. Specifically, a stub structure of a proper shape may be selected based on a frequency band of common-mode noise that needs to be suppressed actually.

In a specific technical solution, the main stub is a rectangular main stub. The rectangular main stub is disposed in parallel with the differential signal line. In other words, the length direction of the rectangular main stub is parallel to an extension direction of the differential signal line. The auxiliary stub is axisymmetric to the differential signal line. In this solution, the stub structure is symmetrically disposed with respect to the differential signal line, and has little impact on the differential signal line, and does not affect transmission performance of the differential signal line.

The reference ground layer has a hollow structure, and the hollow structure is located on a periphery of the stub structure. Specifically, it may also be considered that the reference ground layer has an opening, and the stub structure is located in the opening. The hollow structure is symmetrically disposed relative to the differential signal line, and an edge of the reference ground layer and an edge of the stub structure form a contour of the hollow structure. In this solution, the hollow structure does not affect the symmetry of the differential signal line, so that the transmission performance of the differential signal line is not affected.

A shape of an outer edge of the hollow structure is not limited. For example, the outer edge may be in a rectangle, a circle, a trapezoid, or a D shape, or certainly may be another symmetric structure.

In a specific technical solution, the differential signal line includes primary wiring and secondary wiring, where a layer of the primary wiring on the multilayer circuit board is different from a layer of the secondary wiring on the multilayer circuit board. The primary wiring and the secondary wiring are connected through a signal hole, and the signal hole passes through the hollow structure of the reference ground layer. In other words, the hollow structure in this technical solution is used to form a stub structure on one hand, and is further used to allow the signal hole to pass through on the other hand. This is beneficial to simplifying a structure of the multilayer circuit board, and simplify the preparation process of the multilayer circuit board.

The multilayer circuit board further includes a defected ground structure (DGS), where the defected ground structure is disposed on the reference ground layer. The defected ground structure is cascaded with the stub structure, so that a filtering bandwidth can be increased, to improve a tolerance capability of a circuit board assembly.

A person skilled in the art may set widths of the auxiliary stub 1332 and the main stub 1331 with reference to a processing capability and product performance requirement. Generally, a larger width indicates a lower resonance frequency of the common-mode noise that can be suppressed. If the adjustment frequency needs to be increased, the width may be reduced. However, due to a limitation of the processing capability, the width cannot be reduced infinitely. Generally, the width may be set to 4 mils to 10 mils. To better increase the resonance frequency of the common-mode noise, the width may be set to about 4 mils.

In this application, the differential signal line 131 includes two signal lines, the two signal lines are disposed in parallel, a line width of each signal line may be 4 mils to 10 mils, and a spacing between the two signal lines may be 5 mils to 20 mils. In an embodiment, the spacing may be 8 mils to 10 mils. In this way, a coupling capability between the two signal lines can be ensured, to meet the transmission performance of the differential signal line, and enough space can be reserved for the main stub, so that a vertical projection surface of the main stub does not overlap with the differential signal line. In this way, the transmission performance of the differential signal line is not affected.

According to a second aspect, this application further provides a circuit board assembly, where the circuit board assembly includes the multilayer circuit board in any one of the foregoing technical solutions, and further includes a chip, where the chip is connected to a differential signal line. One end of the differential signal line is connected to the chip, and the other end may be connected to a connector, or may be connected to another electronic component. This is not limited in this application. The circuit board assembly has a strong capability of resisting common-mode interference, an area of an anti-interference structure is small, and a wiring density may be high.

In a specific technical solution, a type of the circuit board assembly is not limited. For example, the circuit board assembly may be a chip package, an electronic module, or a board. Any circuit board assembly having a multilayer circuit board may be a circuit board assembly in the technical solutions of this application.

According to a third aspect, this application provides an electronic device, where the electronic device includes a housing and the multilayer circuit board in any one of the foregoing technical solutions, and the multilayer circuit board is disposed in the housing. For an anti-interference capability of the multilayer circuit board in the electronic device, specifically, a type of the electronic device is not limited. For example, the electronic device may be a server or a mobile terminal.

**BRIEF DESCRIPTION OF DRAWINGS**

FIG. 1 is a schematic diagram of a structure of an electronic device according to an embodiment of this application;
FIG. 2 is a schematic diagram of another structure of an electronic device according to an embodiment of this application;
FIG. 3 is a schematic exploded diagram of a structure of a circuit board assembly according to an embodiment of this application;
FIG. 4 is a schematic diagram of a partial cross-sectional structure of a circuit board assembly according to an embodiment of this application;
FIG. 5 is a schematic top view of a structure of a multilayer circuit board according to an embodiment of this application;
FIG. 6 is a diagram of simulation analysis and comparison of distribution of resonance point electric fields according to an embodiment of this application;
FIG. 7 is a diagram of simulation analysis and comparison of distribution of a resonance point magnetic field according to an embodiment of this application;

FIG. 8 is a diagram of simulation analysis and comparison of a common-mode insertion loss according to an embodiment of this application;
FIG. 9 is a diagram of simulation analysis and comparison of a differential-mode insertion loss according to an embodiment of this application;
FIG. 10 is a diagram of simulation analysis and comparison of a differential-mode return loss according to an embodiment of this application;
FIG. 11 is a schematic diagram of a structure of a differential-mode magnetic field of a multilayer circuit board according to an embodiment of this application;
FIG. 12 is a schematic diagram of a structure of a differential-mode electric field of a multilayer circuit board according to an embodiment of this application;
FIG. 13 is a schematic diagram of a structure of a common-mode magnetic field of a multilayer circuit board according to an embodiment of this application;
FIG. 14 is a schematic diagram of a structure of a common-mode electric field of a multilayer circuit board according to an embodiment of this application;
FIG. 15A to FIG. 15I are schematic diagrams of shapes of various stub structures according to an embodiment of this application;
FIG. 16A to FIG. 16C are schematic diagrams of shapes of outer edges of hollow structures of various reference ground layers according to an embodiment of this application; and
FIG. 17 is a schematic top view of another structure of a multilayer circuit board according to an embodiment of this application.

Reference numerals:

100: server; 110: housing;
120: power supply apparatus; 130: heat dissipation apparatus;
200: mobile terminal; 210: housing;
1: circuit board assembly; 11: chip;
12: connector; 13: multilayer circuit board;
131: differential signal line; 1311: primary wiring;
1312: secondary wiring; 132: reference ground layer;
1321: hollow structure; 133: stub structure;
1331: main stub; 1332: auxiliary stub;
1333: root; 1334: branch;
134: reference ground layer corresponding to a secondary wiring; 2: electric field;
3: magnetic field; 4: defected ground structure;
M: symmetry axis.

## DESCRIPTION OF EMBODIMENTS

To facilitate understanding of a multilayer circuit board, a circuit board assembly, and an electronic device provided in embodiments of this application, the following describes application scenarios of the multilayer circuit board, the circuit board assembly, and the electronic device. With development of electronic information technologies, operating efficiency of electronic devices is continuously improved, a rate of a high-speed chip is increasingly high, and common-mode noise is more likely to be generated. The high-speed chip transmits a signal through a differential signal line. To improve signal accuracy, the high-speed chip further includes a reference ground layer. The circuit board assembly in embodiments of this application includes the multilayer circuit board, and the differential signal line and the reference ground layer are disposed at different layers of the multilayer circuit board. In the conventional technology, in order to suppress noise generated by a circuit board assembly, a defected ground structure (Defected Ground Structure, DGS), a wiring filter, a balanced broadband tunable common-mode filter, and the like are disposed on a multilayer circuit board, and a structure size in the solutions is too large to meet high-frequency and high-density wiring requirements of a current product board.

Terms used in the following embodiments are merely intended to describe specific embodiments, but are not intended to limit this application. The terms "one", "a", and "this" of singular forms used in this specification and the appended claims of this application are also intended to include expressions such as "one or more", unless otherwise specified in the context clearly.

Reference to "an embodiment", "a specific embodiment", or the like described in this specification indicates that one or more embodiments of this application include a specific feature, structure, or characteristic described with reference to embodiments. Terms "include", "contain", "have", and variants of the terms all mean "include but are not limited to", unless otherwise specifically emphasized in other ways.

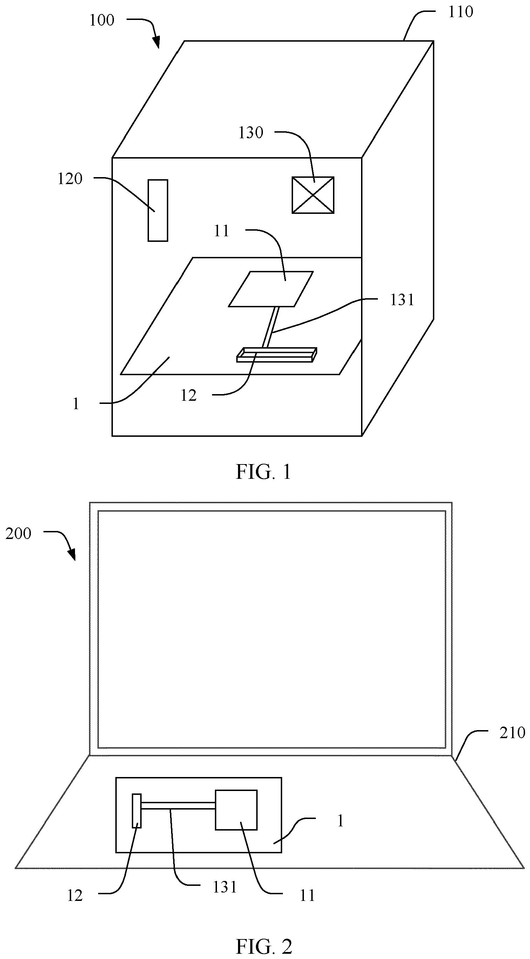

This application provides an electronic device. A specific type of the electronic device is not limited in embodiments of this application. For example, the electronic device may be a server, a mobile terminal, an optical module, a switch, or the like. FIG. 1 is a schematic diagram of a structure of an electronic device according to an embodiment of this application. As shown in FIG. 1, in an embodiment, the electronic device is a server 100. The server 100 may include a housing 110, a power supply apparatus 120, a heat dissipation apparatus 130, and a circuit board assembly 1. The power supply apparatus 120, the heat dissipation apparatus 130, and the circuit board assembly 1 are disposed in the housing 110. The power supply apparatus 120 is connected to the circuit board assembly 1, and is configured to supply power to an electronic component on the circuit board assembly 1. The heat dissipation apparatus 130 may be configured to dissipate heat for the electronic component on the circuit board assembly 1, so as to ensure normal operation of the circuit board assembly 1.

FIG. 2 is a schematic diagram of another structure of an electronic device according to an embodiment of this application. As shown in FIG. 2, in another embodiment, the electronic device may be a mobile terminal 200, and the mobile terminal 200 may be specifically a notebook computer. The mobile terminal 200 may include a housing 210 and a circuit board assembly 1, and the circuit board assembly 1 is disposed in the housing 210.

A specific type of the circuit board assembly 1 is not limited in embodiments of this application. The circuit board assembly 1 may be a chip package, an electronic module, or a board. Specifically, the chip package is a chip package formed by disposing a chip in the circuit board assembly 1 and packaging the circuit board assembly 1 as an entire structure. Therefore, the circuit board assembly 1 can be conveniently installed and used, and the circuit board assembly 1 has a small volume. The electronic module is an electronic module formed by connecting a multilayer circuit board to an electronic component. Refer to FIG. 1 and FIG. 2. When the circuit board assembly 1 is a board, the board may have a chip 11 and a connector 12, and the chip 11 and the connector 12 are connected through a differential signal line 131.

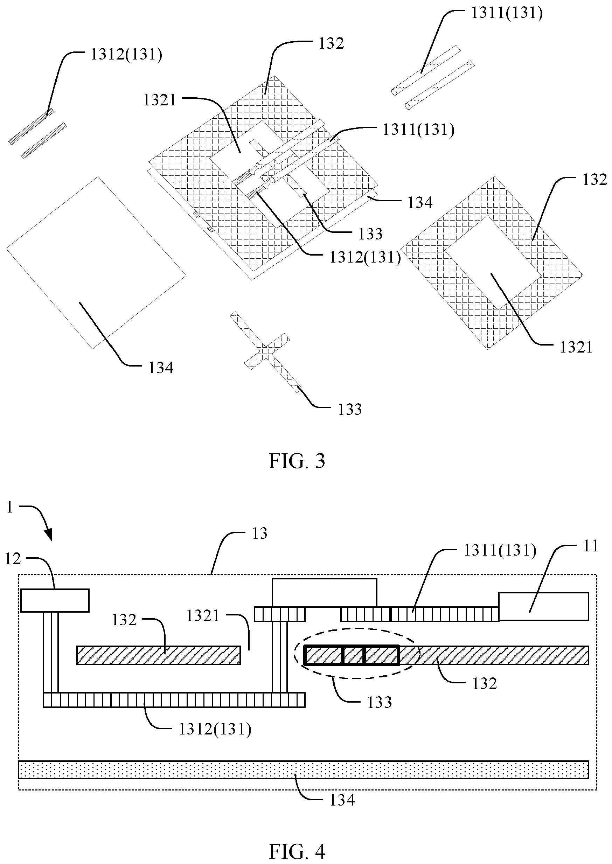

FIG. 3 is a schematic exploded diagram of a structure of a circuit board assembly according to an embodiment of this application. FIG. 4 is a schematic diagram of a partial cross-sectional structure of a circuit board assembly according to an embodiment of this application. As shown in FIG. 3 and FIG. 4, a circuit board assembly 1 in embodiments of this application includes a multilayer circuit board 13, and may further include a chip 11 and a connector 12. The multilayer circuit board 13 includes a differential signal line 131, a reference ground layer 132, and a stub structure 133. The differential signal line 131 is configured to transmit a differential signal, and the reference ground layer 132 is configured to provide a reference signal, so as to improve accuracy of the differential signal line 131. Specifically, when the multilayer circuit board 13 is disposed, a layer of the differential signal line 131 on the multilayer circuit board 13 is different from a layer of the reference ground layer 132 on the multilayer circuit board 13. In other words, the differential signal line 131 and the reference ground layer 132 are located at different layers of the multilayer circuit board 13. Specifically, the reference ground layer 132 may be located at a layer above or below the layer at which the differential signal line 131 is located. This is not limited in this application.

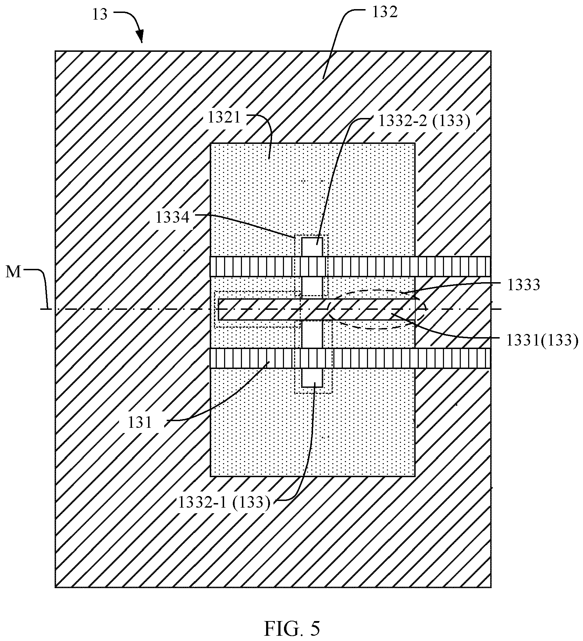

FIG. 5 is a schematic top view of a structure of the multilayer circuit board according to an embodiment of this application. With reference to FIG. 4 and FIG. 5, the stub structure 133 is disposed at the layer of the reference ground layer 132 on the multilayer circuit board 13. In other words, the stub structure 133 and the reference ground layer 132 are located at a same layer. In addition, the stub structure 133 is electrically connected to the reference ground layer 132. Specifically, the stub structure 133 includes a main stub 1331 and an auxiliary stub 1332, where the auxiliary stub 1332 includes two symmetric structures, the two structures are respectively numbered 1332-1 and 1332-2 in the figure, and the two structures are both connected to the main stub 1331. Specifically, the auxiliary stub 1332 is axially symmetrically disposed on two sides of the main stub 1331 relative to a length direction of the main stub 1331, that is, the two structures of the auxiliary stub are respectively disposed on the two sides of the main stub 1331. In the stub structure 133, only one end of the main stub 1331 is connected to the reference ground layer 132, the other end of the main stub 1331 is not connected to the reference ground layer 132, and the auxiliary stub 1332 is not connected to the reference ground layer 132 either. It should be noted that the connection in this application is a physical connection unless otherwise specified. In other words, only the one end of the main stub 1331 is physically connected to the reference ground layer 132, the auxiliary stub 1332 is physically connected to the main stub 1331, and there is no physical connection between the auxiliary stub 1332 and the reference ground layer 132. Specifically, the main stub 1331, the auxiliary stub 1332, and the reference ground layer 132 may be an integrated structure. This is not limited in this application. When the auxiliary stub is specifically disposed, a symmetry axis of the auxiliary stub 1332 may overlap with a symmetry axis that is of the main stub 1331 and that extends in the length direction.

In this solution, the stub structure 133 is disposed on the reference ground layer 132 of the multilayer circuit board 13. The stub structure 133 may form an equivalent capacitor and inductor with a conductive structure between adjacent layers, which is equivalent to disposing a capacitor-inductor resonant circuit on the multilayer circuit board 13. An electric field and a magnetic field generated by a common-mode interference signal are tightly coupled with the stub structure 133, and common-mode energy generated by the circuit board assembly 1 is reflected to a source end, so that the common-mode energy is lost. The source end may specifically refer to an end at which the chip 11 is located. In this solution, only one end of the stub structure 133 is connected to the reference ground plane 132, and an end that is of the main stub 1331 and that is not connected to the reference ground plane 132 may also form an equivalent capacitor. Therefore, compared with an equivalent capacitor formed by a stub structure 133 of a same size and shape with two ends of the main stub 1331 being connected to the reference ground layer 132, the equivalent capacitor formed in the technical solution of this application is large, and a resonance frequency of the common-mode noise that can be suppressed is higher. In other words, based on a same resonance frequency requirement for suppressing the common-mode noise, a stub in the technical solution of this application may be small and occupy a small board area. In addition, the stub structure 133 in this solution is a simple structure, includes only the main stub 1331 and the auxiliary stub 1332, and occupies less space. For example, the board area occupied by the stub structure 133 may be less than or equal to 2 mm$^2$. Compared with the conventional technology, this solution can save more than 45% of space, which is beneficial to meeting high-frequency and high-density wiring requirements of the circuit board assembly 1. The stub structure 133 has a simple structure and a small size, the stub structure may be prepared at a long distance from adjacent wiring, and even if there is an offset in each part of the structure during preparation of the multilayer circuit board 13, quality of a differential signal is not easily affected. Therefore, a tolerance capability of the multilayer circuit board 13 in the preparation process in this solution is strong.

It should be noted that the main stub includes a long side and a short side, and the length direction of the main stub is an extension direction of the long side of the main stub.

When the stub structure 133 is specifically prepared, a length (a first length) that is of the stub structure 133 and that is parallel to an extension direction of the differential signal line 131 may be less than or equal to 2 mm. In this embodiment, the main stub 1331 and the auxiliary stub 1332 of the stub structure 133 are used as a whole, and a maximum length that is of an overall size of the stub structure and that is parallel to the extension direction of the differential signal line 131 is less than or equal to 2 mm. The size of the stub structure 133 in the technical solutions of this application is small, which helps reduce the board area occupied by the stub structure.

A length (a second length) that is of the stub structure and that is perpendicular to the extension direction of the differential signal line is less than or equal to 1 mm. In this embodiment, the main stub 1331 and the auxiliary stub 1332 of the stub structure 133 are used as a whole, and a maximum length that is of the overall size of the stub structure and that is perpendicular to the extension direction of the differential signal line 131 is less than or equal to 1 mm. Similarly, the size of the stub structure in the technical solutions of this application is small, which helps reduce the board area occupied by the stub structure, where the board area is equal to the first length * the second length. For example, the board area occupied by the stub structure may be less than or equal to 2 mm$^2$.

In a specific technical solution, the layer of the differential signal line 131 on the multilayer circuit board 13 is adjacent to the layer of the reference ground layer 132 on the multilayer circuit board 13. In this case, filtering effect of the stub structure is better, and a wiring distance is reduced.

The auxiliary stub 1332 may be directly connected to the main stub 1331, or may be connected to the main stub 1331 by using another structure. In a specific embodiment, the auxiliary stub 1332 and the main stub 1331 may be an integrated structure. This embodiment facilitates preparation of the stub structure, and helps improve reliability of a connection between the auxiliary stub 1332 and the main stub 1331. In a further embodiment, the stub structure and the reference ground layer 132 are an integrated structure, and the reference ground layer 132 and the stub structure may be formed by using one process, so as to facilitate preparation of the multilayer circuit board 13 and simplify a preparation process of the multilayer circuit board 13.

A person skilled in the art may set widths of the auxiliary stub 1332 and the main stub 1331 with reference to a processing capability and product performance requirement. Generally, a larger width indicates a lower resonance frequency of the common-mode noise that can be suppressed. If the adjustment frequency needs to be increased, the width may be reduced. However, due to a limitation of the processing capability, the width cannot be reduced infinitely. Generally, the width may be set to 4 mils to 10 mils. To better increase the resonance frequency of the common-mode noise, the width may be set to about 4 mils.

Still refer to FIG. 5. In a specific embodiment, the main stub 1331 of the stub structure 133 is a rectangular main stub, the main stub 1331 is disposed in parallel with the differential signal line 131, and the auxiliary stub 1332 is axially symmetric relative to the differential signal line 131. In this solution, the entire stub structure is symmetrically disposed relative to the differential signal line 131. Specifically, it may be understood that the differential signal line 131 includes two signal lines, the two signal lines are disposed in parallel, a line width of each signal line may be 4 mils to 10 mils, and a spacing between the two signal lines may be 5 mils to 20 mils. In an embodiment, the spacing may be 8 mils to 10 mils. In this way, a coupling capability between the two signal lines can be ensured, to meet transmission performance of the differential signal line, and enough space can be reserved for the main stub, so that a vertical projection surface of the main stub does not overlap with the differential signal line. In this way, the transmission performance of the differential signal line is not affected. The two differential signal lines have a symmetry axis M. The shape of the stub structure 133 is symmetrically disposed with respect to the symmetry axis M. Specifically, the differential signal line 131 formed by the two signal lines may be further simplified and understood as one line, and is used as the symmetry axis. In this solution, the stub structure is symmetrically disposed relative to the differential signal line 131, and an equivalent circuit generated by the stub structure does not affect symmetry of the differential signal line 131, so that the transmission performance of the differential signal line 131 is not affected.

In addition, the reference ground layer 132 has a hollow structure 1321, and the hollow structure 1321 is located on a periphery of the stub structure. In other words, an edge of the reference ground layer 132 and an edge of the stub structure 133 form a contour of the hollow structure 1321. In the technical solutions of this application, there is no special requirement for the contour of the hollow structure 1321. However, the hollow structure 1321 may be symmetrically disposed relative to the differential signal line 131, so that the hollow structure 1321 does not affect the symmetry of the differential signal line 131, and the transmission performance of the differential signal line 131 is not affected.

It should be noted that, in the technical solutions of this application, one stub structure may be correspondingly disposed for each group of differential signal lines.

Refer to FIG. 4 and FIG. 5. When the multilayer circuit board 13 is specifically disposed, the differential signal line 131 may include primary wiring 1311 and secondary wiring 1312. Specifically, the primary wiring 1311 is a part that is of the differential signal line 131 and that is close to an end at which the chip 11 is located, and the secondary wiring 1312 is a part that is of the differential signal line 131 and that is close to an end at which the connector 12. A layer of the primary wiring 1311 on the multilayer circuit board 13 is different from a layer of the secondary wiring 1312 on the multilayer circuit board 13. In a specific embodiment, the reference ground layer 132 is located between the layer at which the primary wiring 1311 is located and the layer at which the secondary wiring 1312 is located. A signal hole is located in the hollow structure 1321 of the reference ground layer 132. In other words, the signal hole passes through the hollow structure 1321 of the reference ground layer 132. This solution facilitates manufacturing of the signal hole, and the signal hole is not easily connected to another structure. This ensures reliability of connection of the differential signal line 131. In this solution, the hollow structure 1321 used to form the stub structure may be further used to form the signal hole, which is beneficial to simplifying the structure of the multilayer circuit board 13. The primary wiring 1311 and the secondary wiring 1312 may be directly connected, or may be connected by using an electronic component. The electronic component may be specifically a capacitor or a resistor.

Certainly, in another embodiment, the entire differential signal line may be located at a same layer. This is not specifically limited in this application.

Still refer to FIG. 5. The stub structure 133 may be specifically in a cross shape. The stub structure 133 includes a first extending part extending in a first direction and a second extending part disposed in a cross manner with the first extending part. The first extending part is electrically connected to the reference ground layer 132. A region in which the first extension part intersects with the second extension part is a crosspoint, a region between the crosspoint of the stub structure 133 and a point connecting the stub structure 133 and the reference ground layer 132 is a root 1333 of the stub structure 133, and remaining parts are branches 1334 of the stub structure 133. For example, in the embodiment shown in FIG. 5, it may be considered that the stub structure 133 includes the root 1333 (a stub structure in a dashed ellipse box in the figure) and three branches 1334 (stub structures in three dashed boxes in the figure). The stub structure 133 enables the multilayer circuit board 13 to form a capacitor-inductor resonant circuit, and the resonance frequency of the common-mode noise that can be suppressed by the stub structure 133 meets f:

$$f = \frac{1}{2\pi\sqrt{LC}}$$

In this formula, L is an equivalent inductor of the stub structure 133, and C is an equivalent capacitor of the stub structure 133.

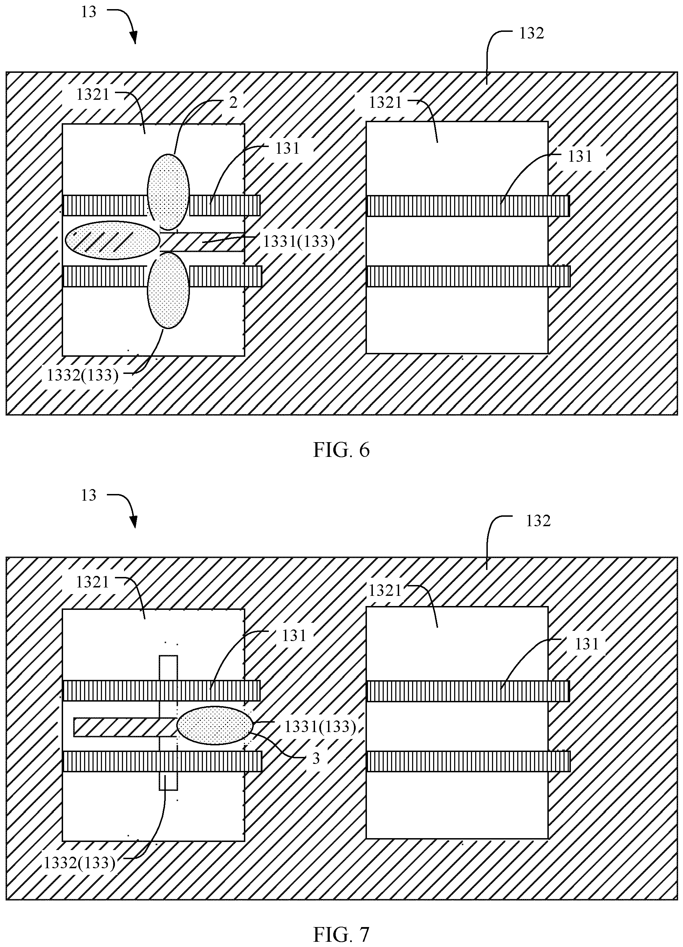

The inventor makes a simulation analysis on the technical solutions of this application. FIG. 6 is a diagram of simulation analysis and comparison of distribution of a resonance point electric field according to an embodiment of this application. With reference to FIG. 5 and FIG. 6, distribution of resonance point electric fields 2 of a multilayer circuit board 13 having a cross-shaped stub structure 133 and distribution of resonance point electric fields 2 of a multilayer circuit board 13 having no cross-shaped stub structure 133 are separately analyzed. It can be learned that the electric fields 2 are mainly distributed in regions in which the branches 1334 of the stub structure 133 are located. In this case, the branch 1334 may form an equivalent capacitor. A length of the branch 1334 affects a value of the equivalent capacitor. A longer branch 1334 indicates a larger equivalent capacitor and a lower frequency of suppressed common-mode noise.

FIG. 7 is a diagram of simulation analysis and comparison of distribution of a resonance point magnetic field according to an embodiment of this application. With reference to FIG. 5 and FIG. 7, distribution of a resonance point magnetic field 3 of a multilayer circuit board 13 having a cross-shaped stub structure 133 and distribution of a resonance point magnetic field 3 of a multilayer circuit board 13 having no cross-shaped stub structure 133 are separately analyzed. It can be learned that the magnetic field 3 is mainly distributed in a region of the root 1333 of the stub structure 133. In this case, the root 1333 may form an equivalent inductor. A length of the root 1333 affects a value of the equivalent inductor. A longer root 1333 indicates a larger equivalent inductor and a lower frequency of suppressed common-mode noise.

In embodiments of this application, the structure of the stub structure 133 is designed with an appropriate size based on the foregoing design principle (for example, an effective occupied area is less than a specific value, for example, less than 2 mm$^2$), so that a frequency of the common-mode noise suppressed by the stub structure 133 is greater than or equal to 10 GHz. In other words, in the technical solutions of this application, a small-sized stub structure 133 may be designed to suppress common-mode noise with a high frequency. It should be noted that, to meet various types of specific performance, a person skilled in the art may obtain a specific structural shape and size of the stub structure through simulation and testing based on the foregoing design principle. In addition, a minimum size of the stub structure may also be determined with reference to a mechanical processing capability and an actual product requirement, for example, may be approximately equal to 0.4 mm $\times$ 0.5 mm.

An example in which the stub structure 133 is in a cross shape is used. The following enumerates a specific embodiment. In this embodiment, the multilayer circuit board 13 of the circuit board assembly 1 includes a four-layer structure: a first layer, a second layer, a third layer, and a fourth layer in sequence. The primary wiring 1311 is disposed at the first layer, the reference ground layer 132 corresponding to the primary wiring 1311 is disposed at the second layer, the secondary wiring 1312 is disposed at the third layer, and the fourth layer is a reference ground layer 134 corresponding to the secondary wiring. Specific materials of the primary wiring 1311, the reference ground layer 132, the secondary wiring 1312, and the reference ground layer 134 corresponding to the secondary wiring are not limited, for example, may be copper, or may further include a material with good conductivity like silver. The reference ground layer 132 and the cross-shaped stub structure 133 are symmetrically disposed with respect to the differential signal line 131. The stub structure 133 in the figure is disposed on the reference ground layer 132 corresponding to the primary wiring. The stub structure may alternatively be disposed on the reference ground layer 134 corresponding to the secondary wiring. Alternatively, both the reference ground layer 132 corresponding to the primary wiring and the reference ground layer 134 corresponding to the secondary wiring are provided with the stub structure 133.

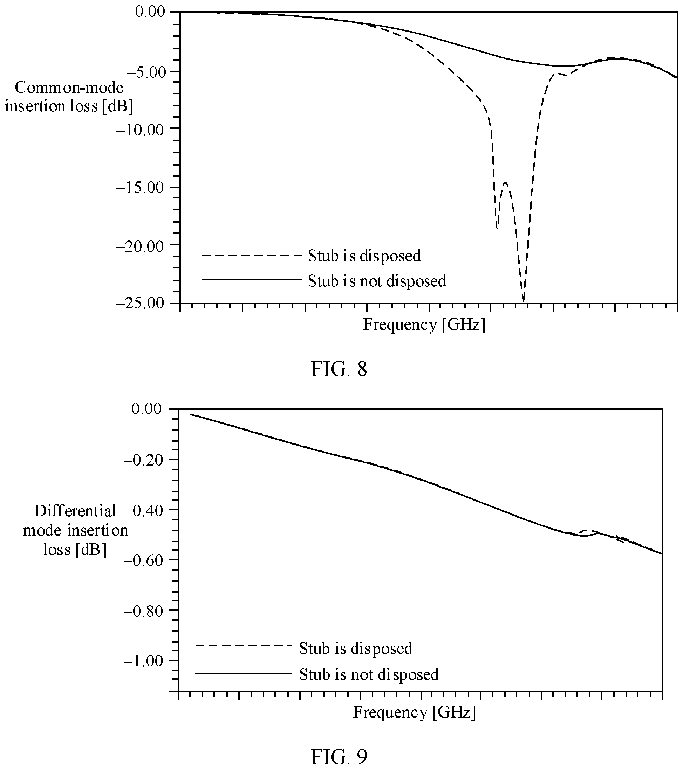

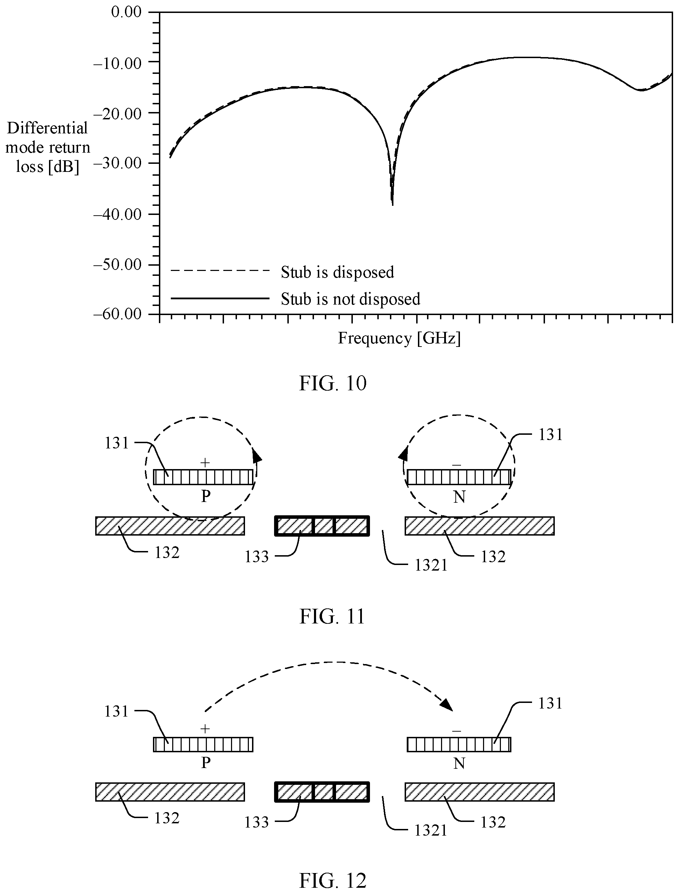

FIG. 8 is a diagram of simulation analysis and comparison of a common-mode insertion loss according to an embodiment of this application. As shown in FIG. 8, in an embodiment of this application, a common-mode insertion loss value of a circuit board assembly 1 provided with a stub structure 133 is low. In the conventional technology, when the stub structure 133 is not disposed, a common-mode insertion loss value is high. FIG. 9 is a diagram of simulation analysis and comparison of a differential-mode insertion loss according to an embodiment of this application. As shown in FIG. 9, in an embodiment of this application, see the two curves, a difference between a differential-mode insertion loss of a circuit board assembly 1 provided with a stub structure 133 and a differential-mode insertion loss, in the conventional technology, obtained when the stub structure 133 is not provided is not greater than 0.1 dB, and is within an acceptable range. FIG. 10 is a diagram of simulation analysis and comparison of a differential-mode return loss according to an embodiment of this application. As shown in FIG. 10, in an embodiment of this application, a difference between a curve of a differential-mode return loss of a circuit board assembly 1 provided with a stub structure 133 and a differential-mode return loss, in the conventional technology, obtained when the stub structure 133 is not provided is small, and is also within an acceptable range.

FIG. 11 is a schematic diagram of a structure of a differential-mode magnetic field of a multilayer circuit board according to an embodiment of this application. As shown in FIG. 11, when differential signal lines 131 transmit differential-mode signals, a middle symmetric surface between two differential signal lines 131 in a group of differential signal lines 131 is a virtual electric wall. A stub structure 133 is added in the middle, and the differential signal is not affected. FIG. 12 is a schematic diagram of a structure of a differential-mode electric field of a multilayer circuit board 13 according to an embodiment of this application. As shown in FIG. 12, when differential signal lines 131 transmit differential-mode signals, a loop formed by a stub structure 133 is parallel to a magnetic line, and is not excited by a magnetic field. Therefore, if the stub structure 133 is disposed, the magnetic field and an electric field that are obtained during transmission of the differential-mode signal are not coupled with the stub structure 133, and transmission of the differential-mode signal by a circuit board assembly 1 is not affected.

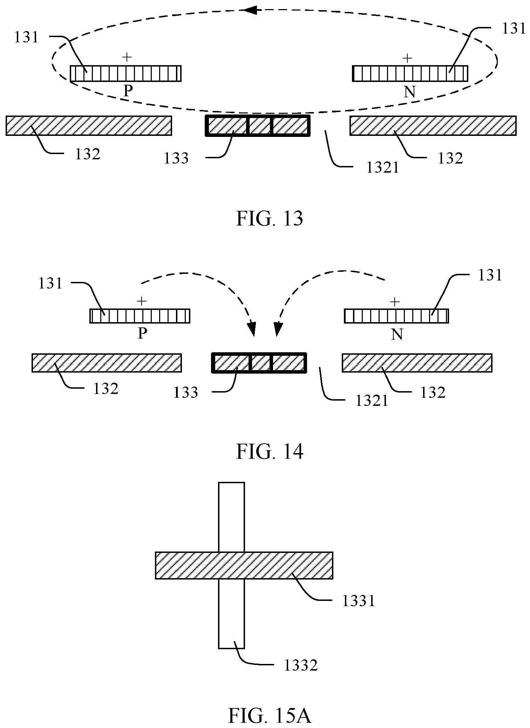

FIG. 13 is a schematic diagram of a structure of a common-mode magnetic field of a multilayer circuit board according to an embodiment of this application. As shown in FIG. 13, when differential signal lines 131 transmit common-mode signals, an electric field of two differential signal lines 131 in a group of differential signal lines 131 ends at a stub structure 133.

FIG. 14 is a schematic diagram of a structure of a common-mode electric field of a multilayer circuit board according to an embodiment of this application. As shown in FIG. 14, when differential signal lines 131 transmit common-mode signals, magnetic fields pass through a stub structure 133 in the middle to form loops. Both an electric field and the magnetic field are resonant at the stub structure 133. At a resonance frequency, common-mode impedance mismatch occurs on differential signals, and common-mode energy is reflected to the source end for dissipation. The common-mode energy cannot continue to propagate to the front, and is not excited by the magnetic field. Therefore, the foregoing stub structure 133 is disposed, so that electromagnetic interference can be suppressed.

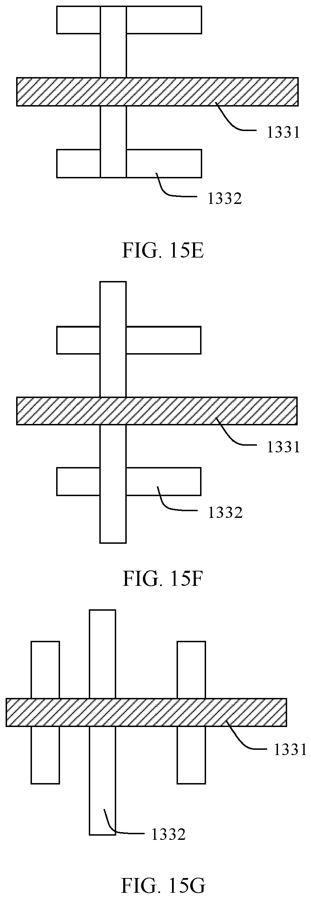

A specific shape of the stub structure 133 is not limited. For example, the stub structure 133 may be in a cross shape, a T shape, an E shape, a 'P shape, or another symmetric structure. It may be understood that the shape of the stub structure 133 herein is only similar to shapes of various characters or letters, but not completely the same. A person skilled in the art may obtain a final shape with reference to the design principle in the foregoing embodiments and various schematic diagrams in FIG. 15A to FIG. 15I.

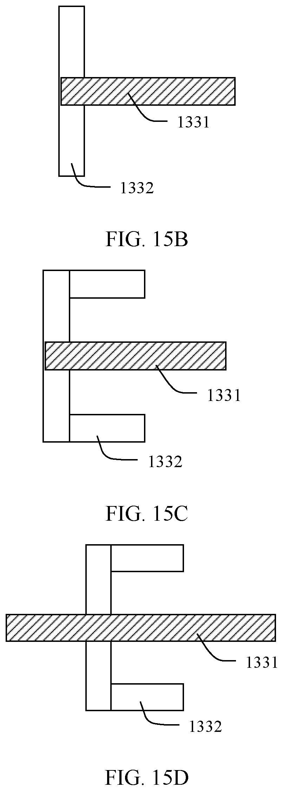

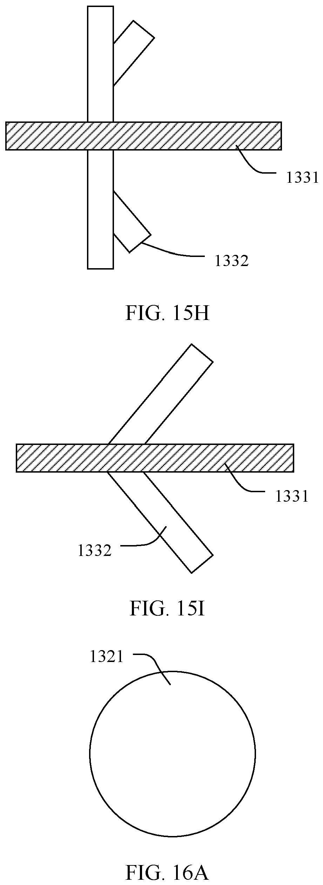

FIG. 15A to FIG. 15I are schematic diagrams of shapes of various stub structures according to an embodiment of this application. A stub structure 133 in an embodiment shown in FIG. 15A is in a cross shape, a stub structure 133 in an embodiment shown in FIG. 15B is in a T shape, a stub structure 133 in an embodiment shown in FIG. 15C is in an E shape, and a stub structure 133 in an embodiment shown in FIG. 15D is in a $\Psi$ shape. In addition, the stub structure 133 only needs to be symmetrically disposed, and may not be in the foregoing shape, for example, a shape of the stub structure 133 in embodiments shown in FIG. 15E to FIG. 15G. In addition, an auxiliary stub 1332 of the stub structure may be parallel to a length direction of a main stub 1331, or an auxiliary stub 1332 of the stub structure may intersect with a length direction of a main stub 1331, that is, the auxiliary stub 1332 may be perpendicular to the main stub 1331 or be at an angle with the main stub 1331. In embodiments shown in FIG. 15H and FIG. 15I, the auxiliary stub 1332 further includes a part that can be obliquely extended.

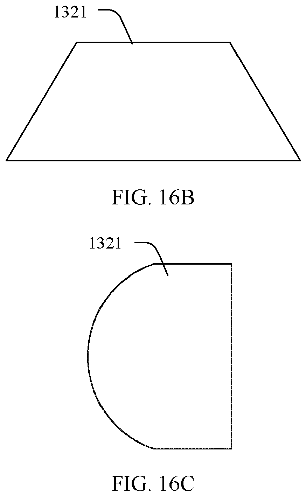

A shape of an outer edge of the hollow structure 1321 is not limited either. For example, the hollow structure 1321 may be a symmetric structure like a rectangle, a circle, a trapezoid, or a D shape. It should be noted that the outer edge of the hollow structure 1321 is an edge that is of the hollow structure 1321 and that is adjacent to the reference ground layer 132, that is, the stub structure 133 is ignored. FIG. 16A to FIG. 16C are schematic diagrams of a shape of the hollow structure 1321 of the reference ground layer 132 according to an embodiment of this application. In an embodiment shown in FIG. 6, the hollow structure 1321 of the reference ground layer 132 is in a rectangle shape. In an embodiment shown in FIG. 16A, the hollow structure 1321 of the reference ground layer 132 is in a circle shape. In an embodiment shown in FIG. 16B, the hollow structure 1321 of the reference ground layer 132 is in a trapezoid shape. In an embodiment shown in FIG. 16C, the hollow structure 1321 of the reference ground layer 132 is in a D shape. In addition, the hollow structure 1321 only needs to be symmetrically disposed, and may not be in the foregoing shape. This is not limited in this application.

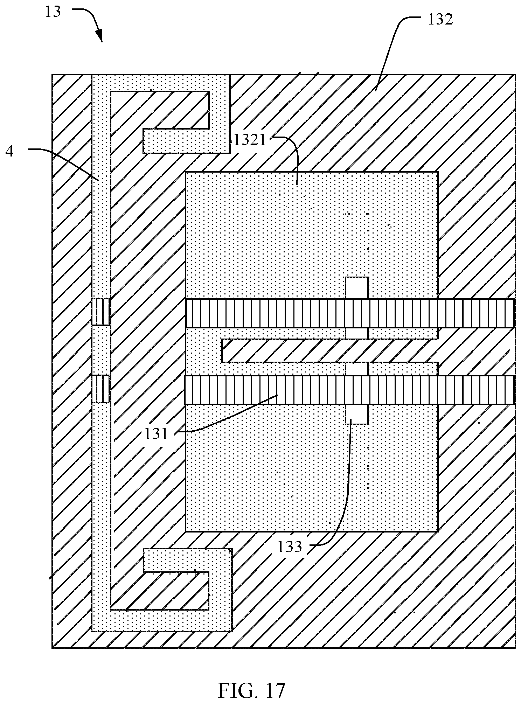

FIG. 17 is a schematic top view of another structure of a multilayer circuit board according to an embodiment of this application. As shown in FIG. 17, in an embodiment, the multilayer circuit board 13 of the circuit board assembly 1 further includes a defected ground structure (DGS) 4, and the defected ground structure 4 is also disposed on the reference ground layer 132. In this solution, both the defected ground structure 4 and the stub structure 133 are disposed on the reference ground layer 132, and the defected ground structure 4 is cascaded with the stub structure 133, so that a filtering bandwidth can be increased, to improve an anti-interference capability of the circuit board assembly 1.

Certainly, a person skilled in the art can make various modifications and variations to this application without departing from the protection scope of this application. In this way, this application is intended to cover these modifications and variations of this application provided that they fall within the scope of the claims of this application and their equivalent technologies.

**Claims**

1. A multilayer circuit board, comprising a differential signal line, a reference ground layer, and a stub structure connected to the reference ground layer, wherein
a layer of the differential signal line on the multilayer circuit board is different from a layer of the reference ground layer on the multilayer circuit board; the stub structure comprises a main stub and an auxiliary stub, wherein in the stub structure, only one end of the main stub is connected to the reference ground layer, the auxiliary stub is connected to the main stub as an integrated structure, the auxiliary stub is axisymmetric relative to a length direction of the main stub, and the auxiliary stub is not connected to the reference ground layer.

2. The multilayer circuit board according to claim 1, wherein the main stub is a rectangular main stub, the main stub is disposed in parallel with the differential signal line, and the auxiliary stub is axisymmetric to the differential signal line.

3. The multilayer circuit board according to claim 1 or 2, wherein the stub structure is in a cross shape, a T shape, an E shape, or a T shape.

4. The multilayer circuit board according to any one of claims 1 to 3, wherein the reference ground layer has a hollow structure, the hollow structure is located on a periphery of the stub structure, and the hollow structure is symmetrically disposed relative to the differential signal line.

5. The multilayer circuit board according to claim 4, wherein an outer edge of the hollow structure is in a rectangle shape, a circle shape, a trapezoid shape, or a D shape.

6. The multilayer circuit board according to claim 4 or 5, wherein the differential signal line comprises primary wiring and secondary wiring, a layer of the primary wiring on the multilayer circuit board is different from a layer of the secondary wiring on the multilayer circuit board, the primary wiring and the secondary wiring are connected through a signal hole, and the signal hole passes through the hollow structure of the reference ground layer.

7. The multilayer circuit board according to any one of claims 1 to 6, wherein a length that is of the stub structure and that is parallel to an extension direction of the differential signal line is less than or equal to 2 mm.

8. The multilayer circuit board according to any one of claims 1 to 7, wherein a length that is of the stub structure and that is perpendicular to the extension direction of the differential signal line is less than or equal to 1 mm.

9. The multilayer circuit board according to any one of claims 1 to 8, further comprising a defected ground structure, wherein the defected ground structure is disposed on the reference ground layer.

10. The multilayer circuit board according to any one of claims 1 to 9, wherein a frequency at which common-mode noise is suppressed by the stub structure is greater than or equal to 10 GHz.

11. A circuit board assembly, comprising the multilayer circuit board according to any one of claims 1 to 10, and further comprising a chip, wherein the chip is connected to a differential signal line.

12. The circuit board assembly according to claim 11, wherein the circuit board assembly is a chip package, an electronic module, or a board.

13. An electronic device, comprising a housing and the multilayer circuit board according to any one of claims 1 to 10, wherein the multilayer circuit board is disposed in the housing.

FIG. 1

FIG. 2

1312(131)

132

1311(131)

1321

1311(131)

134

133

1312(131)

134

132

1321

133

FIG. 3

1

12

13

1311(131)

11

132

1321

132

133

1312(131)

134

FIG. 4

FIG. 5

FIG. 6

FIG. 7

FIG. 8

FIG. 9

FIG. 10

FIG. 11

FIG. 12

131 131

+ +

P N

132 133 1321 132

FIG. 13

131 131

+ +

P N

132 133 1321 132

FIG. 14

1331

1332

FIG. 15A

1331

1332

FIG. 15B

1331

1332

FIG. 15C

1331

1332

FIG. 15D

1331

1332

FIG. 15E

1331

1332

FIG. 15F

1331

1332

FIG. 15G

FIG. 15H

FIG. 15I

FIG. 16A

1321

FIG. 16B

1321

FIG. 16C

FIG. 17

## INTERNATIONAL SEARCH REPORT

| International application No. |
| --- |
| **PCT/CN2022/118256** |

**A. CLASSIFICATION OF SUBJECT MATTER**

H05K 1/02(2006.01)i

According to International Patent Classification (IPC) or to both national classification and IPC

**B. FIELDS SEARCHED**

Minimum documentation searched (classification system followed by classification symbols)

H05K

Documentation searched other than minimum documentation to the extent that such documents are included in the fields searched

Electronic data base consulted during the international search (name of data base and, where practicable, search terms used)

CNTXT; CNABS; VEN; WOTXT; USTXT; EPTXT; CNKI: 差分, 接地, differential, ground

**C. DOCUMENTS CONSIDERED TO BE RELEVANT**

| Category* | Citation of document, with indication, where appropriate, of the relevant passages | Relevant to claim No. |
| --- | --- | --- |
| PX | US 11160162 B1 (WESTERN DIGITAL TECHNOLOGIES, INC.) 26 October 2021 (2021-10-26)<br>description, column 1, line 14-column 18, line 8, and figure 1A-figure 9 | 1-13 |
| X | US 2016174362 A1 (DORAN, K. J. et al.) 16 June 2016 (2016-06-16)<br>description, paragraphs 4-96, and figures 1-9 | 1-13 |
| X | KR 101466774 B1 (INDUSTRY-ACADEMIC COOPERATION FOUNDATION, YONSEI UNIVERSITY) 28 November 2014 (2014-11-28)<br>description, paragraphs 6-94, and figures 5-9 | 1-13 |
| X | CN 109842989 A (QUANTA COMPUTER INC.) 04 June 2019 (2019-06-04)<br>description, paragraphs 2-65, and figures 3-7 | 1-13 |
| A | US 2012235764 A1 (ELECTRONICS AND TELECOMMUNICATIONS RESEARCH INSTITUTE) 20 September 2012 (2012-09-20)<br>entire document | 1-13 |

☐ Further documents are listed in the continuation of Box C.          ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **07 November 2022** | **17 November 2022** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2022/118256**

| Patent document cited in search report | | | Publication date (day/month/year) | Patent family member(s) | | | Publication date (day/month/year) |
|---|---|---|---|---|---|---|---|
| US | 11160162 | B1 | 26 October 2021 | None | | | |
| US | 2016174362 | A1 | 16 June 2016 | None | | | |
| KR | 101466774 | B1 | 28 November 2014 | None | | | |
| CN | 109842989 | A | 04 June 2019 | US | 2019166685 | A1 | 30 May 2019 |
| | | | | JP | 2019096857 | A | 20 June 2019 |
| | | | | TW | 201926786 | A | 01 July 2019 |
| | | | | EP | 3490346 | A1 | 29 May 2019 |
| | | | | JP | 6547987 | B2 | 24 July 2019 |
| | | | | TW | 671943 | B1 | 11 September 2019 |
| | | | | US | 10499490 | B2 | 03 December 2019 |
| | | | | CN | 109842989 | B | 29 March 2022 |
| US | 2012235764 | A1 | 20 September 2012 | KR | 20120105264 | A | 25 September 2012 |
| | | | | KR | 101786083 | B1 | 17 October 2017 |

Form PCT/ISA/210 (patent family annex) (January 2015)

24

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111068756